# EUROPEAN PATENT SPECIFICATION

(11) **EP 1 569 502 B1**
(45) Date of publication and mention of the grant of the patent: **15.08.2007**
(21) Application number: 05251108.6
(22) Date of filing: 24.02.2005
(51) Int. Cl.: H05K 1/16, H05K 1/00

(54) **Printed circuit board structure for motor driving device**
Gedruckte Leiterplattenstruktur zum Antrieb eines elektrischen Motors
Structure de circuit imprimé pour un dispositif de commande d'un moteur électrique

(30) Priority: 24.02.2004 JP 2004048585
(43) Date of publication of application: 31.08.2005
(73) Proprietor: FANUC LTD, Minamitsuru-gun, Yamanashi 401-0597 (JP)
(72) Inventor: Suzuki, Naoyuki, Minamitsuru-gun Yamanashi 401-0301 (JP); Inaba, Kiichi, Minamitsuru-gun Yamanashi 401-0301 (JP)
(74) Representative: Billington, Lawrence Emlyn

(56) References cited:
- WO-A-94/22281
- US-A- 3 745 508
- US-A- 5 636 099

## Description

The present invention relates to a printed circuit board structure, and more particularly to a printed circuit board structure suitable for use in an inverter for driving an electric motor.

An inverter device is widely used for driving an induction motor since it drives a general-purpose induction motor efficiently at variable speed. Inverter devices have difference specifications in connection of external cables, rated voltages and allowable input voltages for different usages, and it has been a general practice to modify the whole constitution or components of the inverter to cope with a specific usage.

For instance, a plurality of capacitors are used in parallel for a low-voltage power source specification, and a combination of a serial connection and a parallel connection of capacitors are used for a high voltage power source specification in view of allowable input voltages of the capacitors.

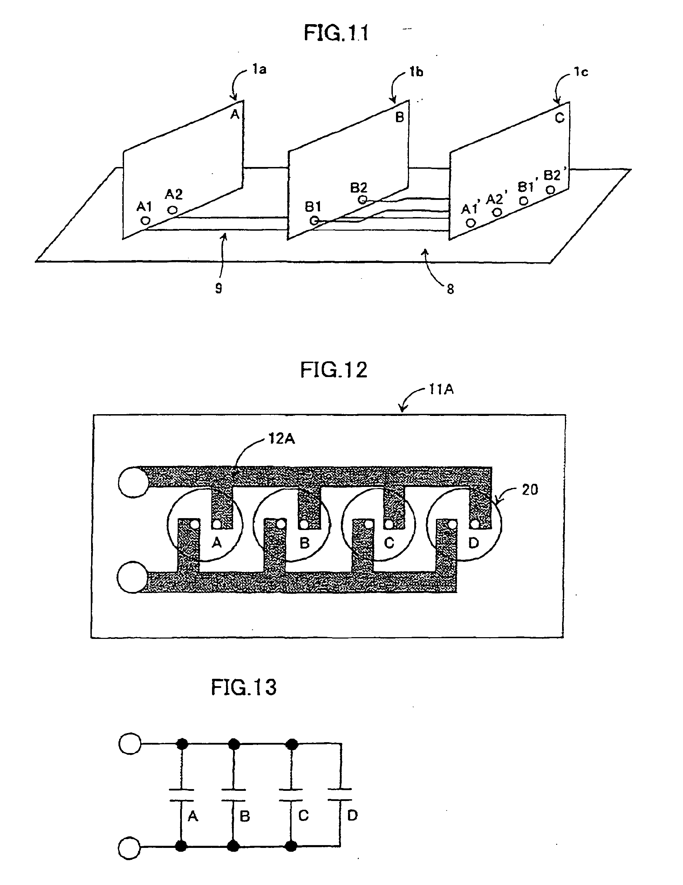

FIG. 12 shows a conventional printed board for a low-voltage power source specification. In FIG. 12, a conductive pattern 12A formed on a circuit board 11A comprises four pairs of confronting electrodes to form capacitors A, B, C and D connected in parallel at portions 20 as indicated by circles. FIG. 13 shows an equivalent circuit of the capacitor circuit formed in this printed circuit board.

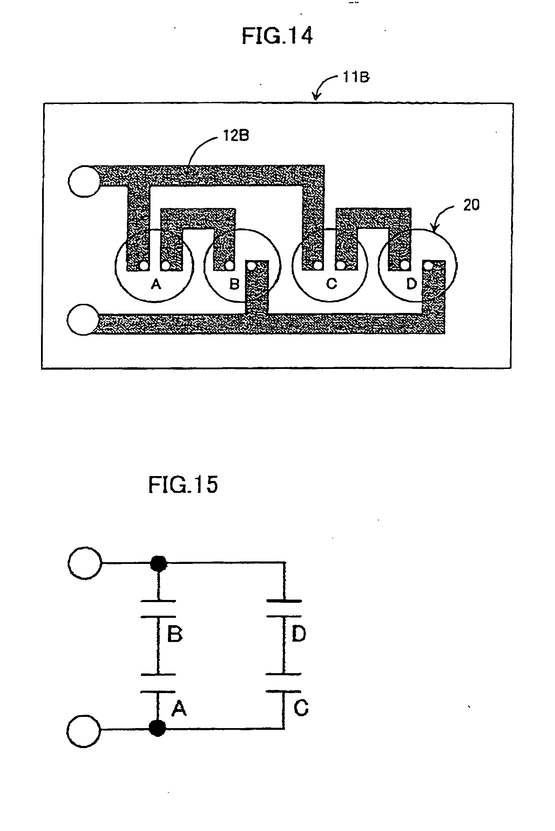

FIG. 14 shows a conventional printed board for a high-voltage power source specification. In FIG. 14, a conductive pattern 12B formed on a circuit board 11B comprises two conducting paths connected with external terminals and independent conducting paths between the two conducting paths. With these conducting paths, a set of capacitors A and B connected in series and a set of capacitors C and D connected in series are formed between the output terminals, and the two sets of capacitors arc connected in parallel. FIG. 15 shows an equivalent circuit of the capacitor circuit formed in this printed circuit board.

It has been proposed to prepare plural kinds of printed circuit boards which have circuit elements of different rated voltages on the same conductive patterns and select one kind of these printed circuit boards to be mounted so that only a power circuit board is changeable with using the same control circuit board, in order to avoid a rise of cost in modification of the whole constitution or components of the inverter device for coping with difference specifications in connection of external cables, rated voltages and allowable input voltages, as seen in JP 06-303779A, for example, paragraphs [0006]-[0009] thereof.

In this conventional arrangement, the printed circuit boards may cope with different voltage specifications by preparing the plural kinds of printed circuit boards having different circuit elements with the same conductive pattern, but this arrangement has a limitation in application to various specifications since the circuit parts have limited allowable input voltages.

An embodiment of the present invention can cope with different input voltage levels by changing connection of circuit parts from a parallel connection to a combination of serial and parallel connections even if an input voltage exceeds an allowable voltage of the circuit parts. Further, the number of kinds of printed circuit boards for constituting an inverter device are reduced by using the same conductive patterns as common elements for forming a capacitor circuit.

A printed circuit board structure of the present invention comprises: a plurality of conductive patterns each including at least one pair of electrodes arranged in confronting relation to form a capacitor, and terminals electrically conducted with the capacitor electrodes; and selective connection means for selectively connecting the terminals of the conductive patterns so that a capacitor circuit having predetermined capacitance is formed.

The selective connection means may comprise one or more short bars formed on a circuit board on which the plurality of conductive patterns are formed. Alternatively, the plurality of conductive patterns may be formed on respective circuit boards, and the selective connection means may comprise a conductive pattern formed on a circuit board separately form the respective circuit boards for the plurality of conductive patterns.

The plurality of conductive patterns may be constituted by a combination of the same electrode arrangements and/or different electrode arrangements.

Any ones of the electrodes, the short bars and the conductive patterns may be formed by artwork.

The capacitor circuit is used for smoothing an input voltage of an inverter for driving an electric motor. In this case, the terminals of the conductive patterns are selectively connected by the selective connection means so that the inverter device has an allowable input voltage appropriate for the input voltage.

According to the above arrangement of the present invention, the same conductive patterns are used as common elements for forming capacitor circuits having different allowable input voltages, and thus the number of kinds of printed circuit boards for constituting an inverter device are reduced.

### BRIEF DESCRIPTION OF THE DRAWINGS

FIG. 1 is a schematic diagram of a printed circuit board according to a first embodiment of the present invention;
FIG. 2 is a diagram showing an equivalent circuit of a capacitor circuit formed in the printed circuit board shown in FIG. 1;
FIG. 3 is a schematic diagram of a printed circuit board obtained by modifying the printed circuit board shown in FIG. 1;
FIG. 4 is a diagram showing an equivalent circuit of a capacitor circuit formed in the printed circuit board of FIG. 3;
FIG. 5 is a schematic diagram of a printed circuit board according to a second embodiment of the present invention;
FIG. 6 is a diagram showing an equivalent circuit of a capacitor circuit formed in the printed circuit board shown in FIG. 5;
FIG. 7 is a schematic diagram of a printed circuit board obtained by modifying the printed circuit board shown in FIG. 5;
FIG. 8 is a diagram showing an equivalent circuit of a capacitor circuit formed in the printed circuit board of FIG. 7;
FIG. 9 is a schematic diagram of a printed circuit board structure according to a third embodiment of the present invention;
FIG. 10 is a schematic diagram of a printed circuit board structure obtained by modifying the printed circuit board structure shown in FIG. 9;
FIG. 11 is a schematic diagram showing connection among printed circuit boards using a connector board;
FIG. 12 is a schematic diagram of a conventional printed board for a low-voltage power source specification;
FIG. 13 is a diagram of an equivalent circuit of a capacitor circuit formed in the printed circuit board shown in FIG. 12;
FIG. 14 is a schematic diagram of a conventional, printed board for a high-voltage power source specification; and
FIG. 15 is a diagram of an equivalent circuit of a capacitor circuit formed in the printed circuit board shown in FIG. 14.

### DETAILED DESCRIPTION

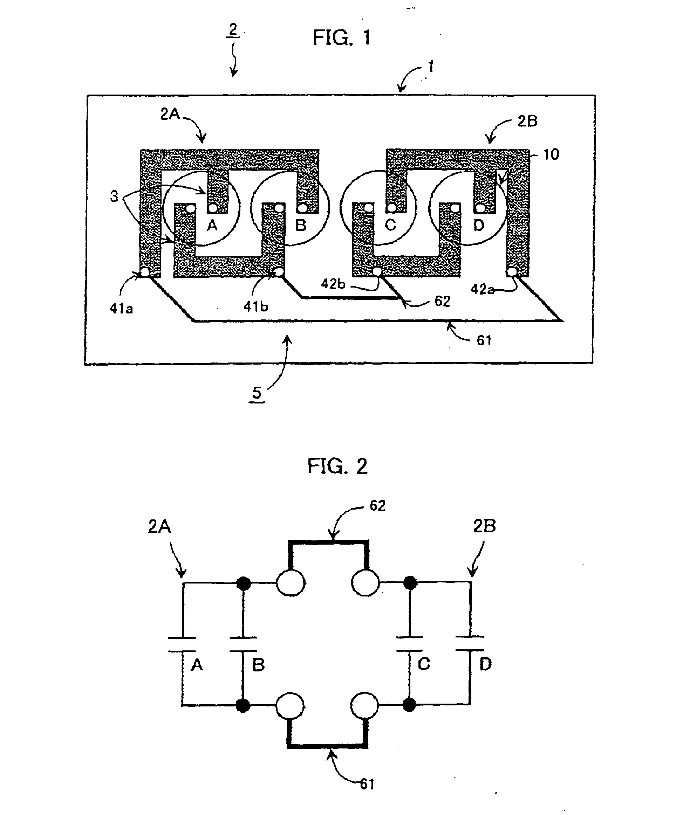

A first embodiment of the present invention will be described referring to FIGS. 1-4. As shown in FIG. 1, a printed circuit board 2 of the first embodiment comprises two conductive patterns 2A, 2B formed on a circuit board 1 and a selective connector 5 for electrically connecting the conductive patterns 2A and 2B. In this embodiment, the selective connector 5 comprises short bars 6.

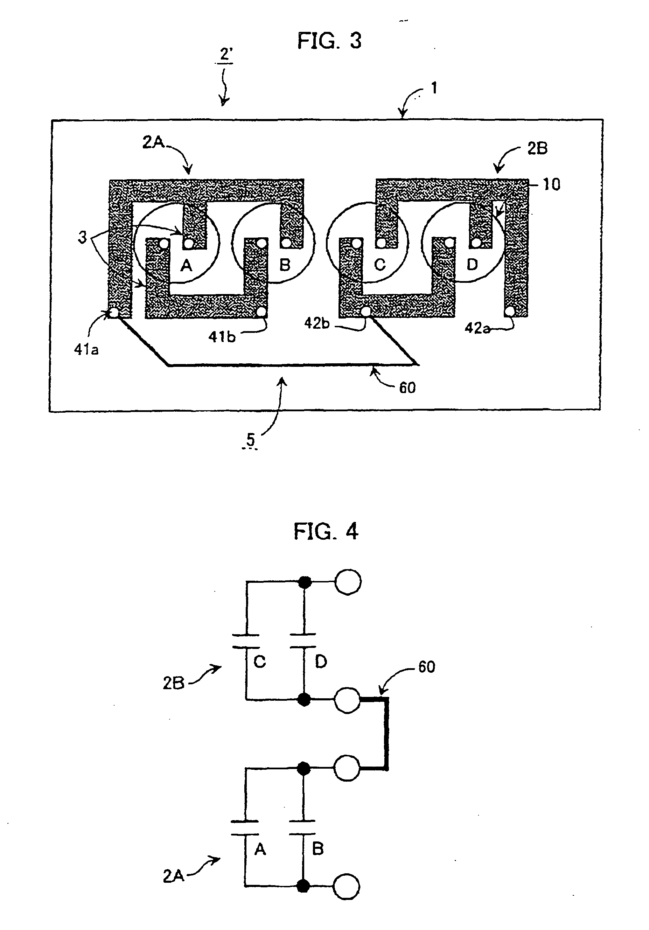

The two conductive patterns 2A and 2B formed on the circuit board 1 have substantially the same patterns and each of the conductive patterns 2A and 2B has two pairs of electrodes 3 arranged in confronting relation. A printed circuit board 2' shown in FIG. 3 has the same conductive patterns 2A and 2B as the printed circuit board 2 shown in FIG. 1, which are connected differently by the short bars to thus have different capacitance from the printed circuit board 2.

The two pairs of electrodes 3 provided in the conductive pattern 2A constitute capacitors A and B in regions 10 indicated by circles in FIGS. 1 and 3, which are connected in parallel. Similarly, the two pairs of electrodes 3 provided in the conductive pattern 2B constitute capacitors C and D in regions 10 indicated by circles in FIGS. 1 and 3, which are connected in parallel.

The conductive pattern 2A has terminals 41a and 41b electrically conducted with the respective confronting electrodes 3, and the conductive pattern 2B has terminals 42a and 42b electrically conducted with the respective confronting electrodes 3. These terminals 41a, 41b, 42a and 42b are selectively connected by the short bars to obtain a predetermined capacitance of the capacitor circuit formed on the circuit board 1.

The printed circuit board 2 shown in FIG. 1 has two short bars 61 and 62. The short bar 61 connects one terminal 41a of the conductive patterns 2 A and one terminal 42a of the conductive pattern 2B, and the short bar 62 connects the other terminal 41b of the conductive patterns 2A and the other terminal 42b of the conductive pattern 2B.

Thus, a parallel circuit of the capacitors A and B and a parallel circuit of the capacitors C and D are connected in parallel by the short bars 61 and 62, so that a capacitor circuit comprising the capacitors A, B, C and D in parallel as a whole is formed on the circuit board 1, an equivalent circuit of which is shown in FIG. 2.

The printed circuit board 2' shown in FIG. 3 is provided with a single short bar 60 which connects the one terminal 41a of the conductive pattern 2A and the other terminal 41b of the conductive pattern 2B. Thus, a parallel circuit of the capacitors A and B and a parallel circuit of the capacitors C and D are connected in series by the single short bar 60 to form a capacitor circuit on the circuit board 1, an equivalent circuit of which is shown in FIG. 4.

It is notable that any arbitrary number of conductive patterns may be provided on the circuit board 1, although two conductive patters 2A and 2B are provided in the circuit board 1 in the above embodiment.

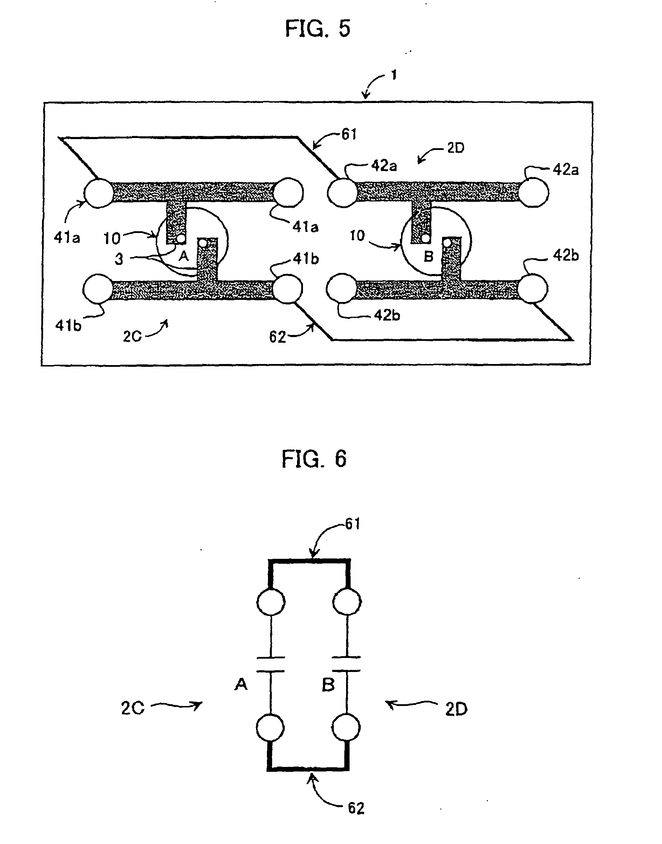

A second embodiment of the present invention is shown in FIGS. 5-8.

As shown in FIG. 5, a printed circuit board of the second embodiment comprises two conductive patterns 2C, 2D formed on a printed board 1 and a selective connector 5 for electrically connecting the conductive patterns 2C and 2D. A single capacitor constitutes a fundamental unit of a capacitor circuit, and a plurality of fundamental units are combined in parallel or serial to form a capacitor circuit having a predetermined capacitance. In this embodiment, the selective connector 5 comprises short bars.

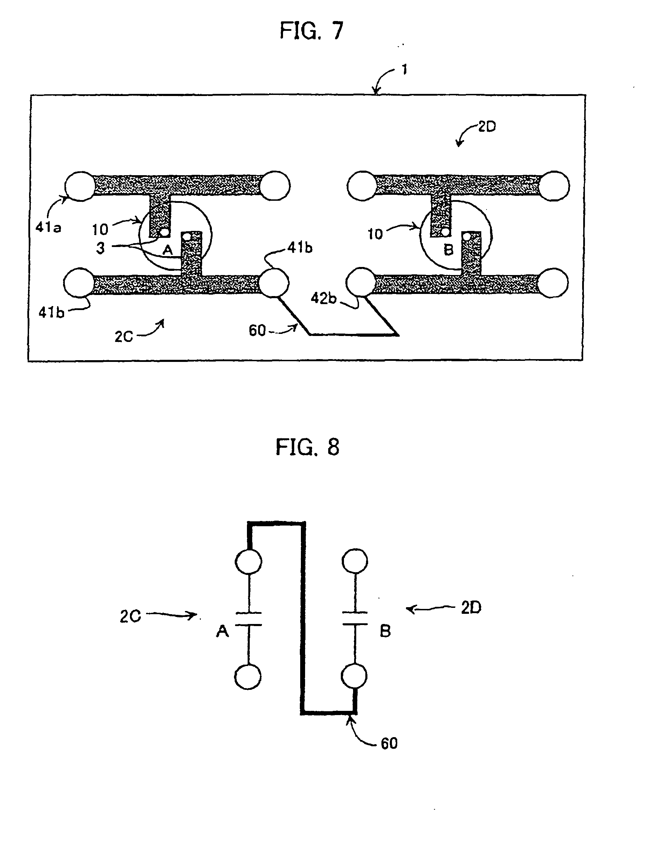

The two conductive patterns 2C and 2D formed on the circuit board 1 have the same patterns and each of the conductive patterns 2C and 2D has one pair of electrodes 3 arranged in confronting relation. A printed circuit board shown in FIG. 7 has the same conductive patterns 2C and 2D as the printed circuit board shown in FIG. 5, which are connected differently by the short bars to thus have different capacitance from the_printed circuit board shown in FIG. 5.

The pair of electrodes 3 provided in the conductive pattern 2C constitutes a capacitor A in a region 10 indicated by a circle in FIGS. 5 and 7. Similarly, the pair of electrodes 3 provided in the conductive pattern 2D constitute capacitors B in a region 10 indicated by a circle in FIGS. 5 and 7. Thus, each of the conductive patterns 2C and 2D constitutes an fundamental unit including one capacitor.

The conductive pattern 2C has terminals 41a and 41b electrically conducted with the respective confronting electrodes 3, and the conductive pattern 2D has terminals 42a and 42b electrically conducted with the respective confronting electrodes 3. These terminals 41a, 41b, 42a and 42b are selectively connected by the short bars to obtain a predetermined capacitance of the capacitor circuit formed on the circuit board 1.

The printed circuit board shown in FIG. 5 has two short bars 61 and 62. The short bar 61 connects the terminal 41a of the conductive patterns 2C and the terminal 42a of the conductive pattern 2D, and the short bar 62 connects the terminal 41b of the conductive patterns 2C and the terminal 42b of the conductive pattern 2D.

Thus, a capacitor circuit comprising the capacitors A and B connected in parallel is formed on the circuit board 1. FIG. 6 shows an equivalent circuit of the capacitor circuit shown in FIG. 5.

The printed circuit board shown in FIG. 7 is provided with a single short bar 60 which connects the terminal 41b of the conductive pattern 2C and the terminal 41b of the conductive pattern 2D. Thus, a capacitor circuit comprising the capacitors A and B connected in series is formed on the circuit board 1. FIG. 8 shows an equivalent circuit of the capacitor circuit shown in FIG. 7.

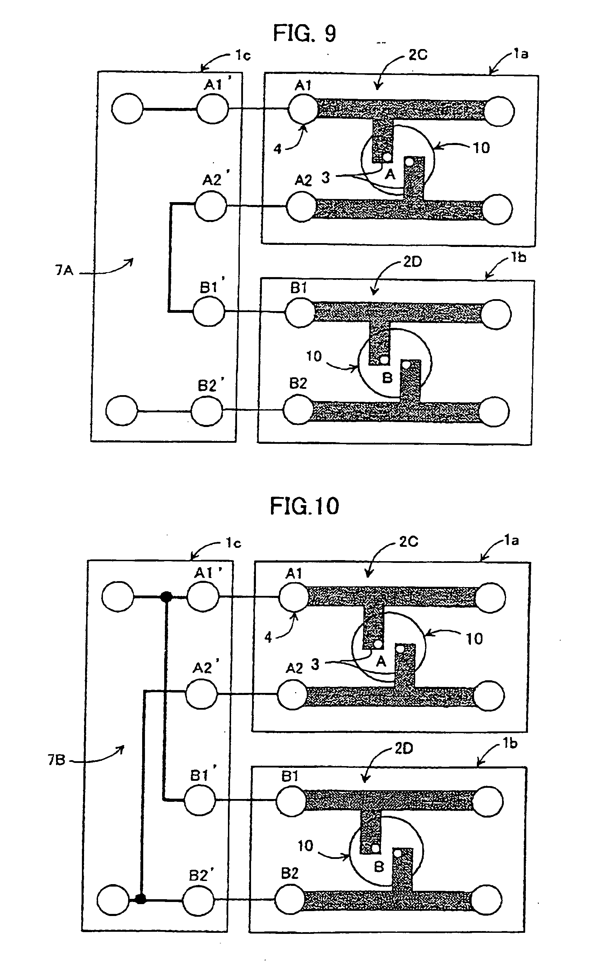

A third embodiment of the present invention are shown in FIGS. 9-11.

In the third embodiment, at least one conductive pattern is formed on each of a plurality of circuit boards 1a, 1b and a conductive pattern as a selective connector is formed on a circuit board 1c. The conductive patterns formed on the circuit boards 1a and 1b are selectively connected by the conductive pattern formed on the circuit board 1c to make a combination of the capacitors formed in the conductive patterns.

One or more short bars are used as the selective connector for selectively connecting the conductive patterns in the first and second embodiments. In this third embodiment, a conductive pattern formed on a circuit board 1c is used as the selective connector.

In a printed circuit board structure shown in FIG. 9, a conductive pattern 2C is formed on a circuit board 1a, a conductive pattern 2D is formed on a circuit board 1b and a conductive pattern 7A is formed on a circuit board 1c. A printed circuit board structure shown in FIG. 10 differs from the printed circuit board structure shown in FIG. 9 in that a different conductive pattern 7B is formed on the circuit board 1c. In this embodiment, the conductive pattern 2C formed on the circuit board 1a and the conductive pattern 2D formed on the circuit board 1b have the same pattern having a pair of electrodes 3 arranged in confronting relation. These conductive patterns 2C and 2D are shown as examples and the conductive patterns may not be restricted to these ones.

The pair of electrode 3 provided in the conductive pattern 2C forms a capacitor A in a region 10 indicated by a circle and the pair of electrode 3 provided in the conductive pattern 2D forms a capacitor B in a region 10 indicated by a circle. Thus, each of the conductive pattern 2C and the conductive pattern 2D constitutes a fundamental unit having one capacitor. The conductive pattern 2C has terminals A1 and A2, and the conductive pattern 2D has terminals B1 and B2.

Terminals A1', A2' and B1', B2' are provided on the circuit board 1c corresponding to the terminals A1, A2 and B1, B2 on the circuit boards 1a and 1b, respectively, and the conductive pattern 7A, is formed for connecting these terminals. The conductive pattern 7A connects the conductive patterns 2C on the circuit board 1a and the conductive pattern 2D on the circuit board 1b. The connection of the conductive patterns 2C and the conductive pattern 2D is changed by using a different conductive pattern on the circuit board 1c. The capacitors formed on the circuit boards 1a and 1b are connected in serial or parallel to obtain a predetermined capacitance of a whole capacitor circuit formed by printed circuit board structure.

In the arrangement shown in FIG. 9, the conductive pattern 7A formed on the circuit board 1c connects the terminal A2 and the terminal B 1 by a short bar and makes the terminal A1 and the terminal B2 be external terminals of the capacitor circuit. The conductive pattern 2C and the conductive pattern 2D are connected by the conductive pattern 7A as the selective connector to form a capacitor circuit comprising the capacitor A on the circuit board 1a and the capacitor B on the circuit board 1b connected in series, an equivalent circuit of which is shown in FIG. 8.

In the arrangement shown in FIG. 10, the conductive pattern 7B formed on the circuit board 1c connects the terminal A1 with the terminal BI and the terminal A2 with the terminal B2 by short bars and makes the terminal A1 and the terminal B2 be external terminals of the capacitor circuit. The conductive pattern 2C and the conductive pattern 2D are connected by the conductive pattern 7B as the selective connector to form a capacitor circuit comprising the capacitor A and the capacitor B connected in parallel, an equivalent circuit of which is shown in FIG. 6.

The connection among the printed circuit boards 1a, 1b and 1c can be done using a connector board 8 as shown in FIG. 11. The connector board 8 has a connection wiring 9 which connects the terminals A1, A2 of the printed board 1a with the terminals A1', A2' of the printed board 1c, and connects the terminals B1, B2 of the printed board 1b with the terminals B1', B2' of the printed board 1c.

With the arrangement shown in FIG. 11, a different capacitance of the capacitor circuit is obtained using the same circuit boards 1a, 1b by replacing the circuit board 1c with one having a different conductive pattern on the connector board 8.

In the above examples shown in FIGS. 9 and 10, a single capacitor is formed on each of the circuit boards 1a, 1b. A plurality of capacitors may be formed on the circuit board and capacitance of each capacitor can be varied by forming a different pattern of the electrodes on the circuit board.

An inverter device may be constituted by using the above printed circuit board structure as a capacitor in an existing circuitry arrangement. When an input voltage of the inverter device or characteristics of external circuitry is changed, an appropriate capacitance of the capacitor circuit is obtained by using a different selective connector. Since different capacitances are obtained by using the same printed circuit boards and replacing the conductive pattern or short bars as the selective connector, the printed circuit boards can be used as common elements of the capacitor circuit.

The above-described embodiments are directed to variation of the allowable input voltage of the capacitor circuitry. The present invention may be applied to a circuitry having elements other than capacitor on the circuit board so that a desired allowable input voltage of the circuitry is obtained by a combination of the elements in series and parallel.

The present invention is not limited to an application on an inverter device but is applicable to a device requiring a change of allowable input voltage with printed circuit boards using as common elements.

## Claims

1. A printed circuit board structure comprising:
a plurality of conductive patterns (2A-2D) each including at least one pair of electrodes (3) arranged in confronting relation to constitute a capacitor (A-D), and terminals (41a, 41b, 42a, 42b, A1, A2, B1, B2) electrically conducted with the capacitor electrodes (3); and
selective connection means (61, 62, 63, 7A, 7B) for selectively connecting the terminals (41a, 41b, 42a, 42b, A1, A2, B1, B2) of said conductive patterns (2A-2D) so that a capacitor circuit having predetermined capacitance can be formed;
wherein the capacitor circuit is used for smoothing an input voltage of an inverter for driving an electric motor, and the terminals (41 a, 41 b, 42a, 42b, A1, A2, B1, B2) of said conductive patterns (2A-2D) are selectively connected by said selective connection means (61, 62, 63, 7A, 7B) so that the inverter device has an allowable input voltage appropriate for the input voltage.

2. A printed circuit board structure according to claim 1, wherein said selective connection means (61, 52, 63, 7A, 7B) comprise one or more short bars formed on a circuit board.

3. A printed circuit board structure according to claim 1 or 2, wherein said plurality of conductive patterns (2C, 2D) are formed on respective circuit boards (1a, 1b) and said selective connection means (7A, 7B) comprises a conductive pattern formed on a circuit board (1c) separately from the respective circuit boards (1a, 1b) for the plurality of conductive patterns (2C, 2D).

4. A printed circuit board structure according to any preceding claim, wherein said plurality of conductive patterns (2A-2D) are constituted by a combination of the same capacitor electrode arrangements and/or different capacitor electrode arrangements.

5. A printed circuit board structure according to any preceding claim, wherein any ones of said capacitor electrodes, said short bars and said conductive patterns are formed by artwork.

## Patentansprüche

1. Leiterplattenstruktur, umfassend
eine Anzahl Leiterbilder (2A-2D), die jeweils mindestens ein Paar Elektroden (3) aufweisen, die einander gegenüber stehen, so dass sie einen Kondensator (A-D) bilden, und Anschlüsse (41a, 41b, 42a, 42b, A1, A2, B1, B2), die mit den Kondensatorelektroden (3) elektrisch leitend verbunden sind; und
selektive Verbindungseinrichtungen (61, 62, 63, 7A, 7B) zum gezielten Verbinden der Anschlüsse (41 a, 41 b, 42a, 42b, A1, A2, B1, B2) der Leiterbilder (2A-2D), so dass man eine Kondensatorschaltung mit vorgegebener Kapazität erhält;
wobei die Kondensatorschaltung verwendet wird zum Glätten der Eingangsspannung eines Wechselrichters für den Antrieb eines Elektromotors, wobei die Anschlüsse (41 a, 41 b, 42a, 42b, A1, A2, B1, B2) der Leiterbilder (2A-2D) von den selektiven Verbindungseinrichtungen (61, 62, 63, 7A, 7B) gezielt verbunden werden, so dass die Wechselrichtereinrichtung eine zulässige und geeignete Eingangsspannung hat.

2. Leiterplattenstruktur nach Anspruch 1, wobei die selektiven Verbindungseinrichtungen (61, 62, 63, 7A, 7B) einen oder mehrere kurze Stäbe umfasst, die auf der Leiterplatine ausgebildet sind.

3. Leiterplatte nach Anspruch 1 oder 2, wobei die Anzahl Leiterbilder (2C, 2D) auf eigenen Platinen (1a, 1b) ausgebildet sind und die selektive Verbindungseinrichtung (7A, 7B) ein Leiterbild auf einer Platine (1c) umfasst, die getrennt ist von den jeweiligen Platinen (1a, 1 b) der Anzahl Leiterbilder (2C, 2D).

4. Leiterplattenstruktur nach irgendeinem der vorstehenden Ansprüche, wobei die Anzahl Leiterbilder (2A-2D) gebildet sind von einer Kombination gleicher Kondensatorelektrodenanordnungen und/oder verschiedener Kondensatorelektrodenanordnungen.

5. Leiterplattenstruktur nach irgendeinem der vorstehenden Ansprüche, wobei von den Kondensatorelektroden, den kurzen Stäbe oder den Leiterbildern ein Element mithilfe einer Druckvorlage erhalten ist.

## Revendications

1. Structure de carte de circuit imprimé comprenant:
plusieurs motifs conducteurs (2A-2D) incluant chacun au moins une paire d'électrodes (3) agencées selon une relation confrontée pour constituer un condensateur (A-D), et des bornes (41a, 41b, 42a, 42b, A1, A2, B1, 82) électriquement en conduction avec les électrodes de condensateur (3); et
des moyens de connection sélectifs (61, 62, 63,7A, 7B) pour relier sélectivement les bornes (41a,41b,42a,42b, A1,A2,B1,B2) desdits motifs conducteurs (2A-2D) de sorte qu'un circuit de condensateur d'une capacité prédéterminée peut être formé;
où le circuit de condensateur est utilisé pour lisser une tension d'entrée d'un onduleur pour entraîner un moteur électrique, et les bornes (41a, 41b, 42a, 42b, A1, A2, B1, B2) desdits motifs conducteurs (2A-2D) sont sélectivement reliés par lesdits moyens de connection sélectifs (61, 62, 63, 7A, 7B) de sorte que le dispositif onduleur possède une tension d'entrée autorisée appropriée pour la tension d'entrée.

2. Structure de carte de circuit imprimé selon la revendication 1, où lesdits moyens de connection sélectifs (61, 62, 63, 7A, 7B) comprennent une ou plusieurs barres courtes formées sur une carte de circuit.

3. Structure de carte de circuit imprimé selon la revendication 1 ou 2, où ladite pluralité de motifs conducteurs (2C,2D) sont formés sur des cartes de circuit respectives (1a, 1b), et lesdits moyens de connection sélectifs (7A, 7B) comprend un motif conducteur formé sur une carte de circuit (1c) séparément des cartes de circuit respectives (1a,1b) pour la pluralité de motifs conducteurs (2C,2D).

4. Structure de carte de circuit imprimé selon l'une quelconque des revendications précédentes, où ladite pluralité de motifs conducteurs (2A-2D) sont formés par une combinaison d'agencements d'électrodes de condensateur identiques et/ou d'agencements d'électrodes de condensateur différents.

5. Structure de carte de circuit imprimé selon l'une quelconque des revendications précédentes, où l'une quelconque desdites électrodes de condensateur, desdites barres courtes et desdits motifs conducteurs sont formés par matriçage.
